# EUROPEAN PATENT APPLICATION

(11) **EP 4 807 569 A1**
(43) Date of publication of application: **16.09.2026**
(21) Application number: 25217324.0
(22) Date of filing: 20.11.2025
(51) Int. Cl.: G06F 13/16, G06F 13/40, G06F 13/42, G06F 1/3234, G06F 1/3296, G06F 3/06, H04L 5/00, H04L 5/14, G06F 1/3206, G11C 5/14, G11C 29/02

(54) **STORAGE DEVICE, METHOD OF OPERATING STORAGE DEVICE, AND STORAGE SYSTEM**

(30) Priority: 20.11.2024 KR 20240166643
(71) Applicant: Samsung Electronics Co., Ltd., Suwon-si, Gyeonggi-do 16677 (KR)
(72) Inventor: PARK, Soojung, Suwon-si (KR); KIM, Minkyu, Suwon-si (KR); SEONG, Jeonghun, Suwon-si (KR)
(74) Representative: Marks & Clerk LLP

(57) **Abstract**

Storage systems and methods of operating storage systems are provided. In one aspect, a storage system includes: a host (100) configured to provide power voltage, and a storage device (200) configured to generate a plurality of candidate voltages based on the power voltage (S103), generate analysis data (S105) including a plurality of state data indicating a state of the storage device by applying each of the plurality of candidate voltages to a host interface, and drive the host interface with a driving voltage determined based on the analysis data (S115), wherein the host interface configured to transmit and receive a plurality of packets with the host (100).

## Description

### BACKGROUND

Recently, PCIe (Peripheral Component Interconnect Express)-based non-volatile memory express (NVMe) has been actively researched and applied to storage devices. As PCIe-based NVMe technology has advanced, the speed of storage devices has increased, but this has led to issues of increased power consumption and heat generation. The increased power consumption and heat generation may raise issues of system quality degradation. Accordingly, technological improvements are desired to ensure power efficiency and quality stability in order to stably support high-speed data transmission based on PCIe.

### SUMMARY

The present disclosure provides a storage device, a method of driving the storage device, and a storage system capable of achieving improved power efficiency.

A storage system according to one implementation comprising: a host configured to provide power voltage, and a storage device configured to generate a plurality of candidate voltages based on the power voltage, generate analysis data including a plurality of state data indicating a state of the storage device by applying each of the plurality of candidate voltages to a host interface, and drive the host interface with a driving voltage determined based on the analysis data, wherein the host interface configured to transmit and receive a plurality of packets with the host.

A method of operating a storage system according to one implementation comprising applying, by a host, a power voltage to a storage device; generating a plurality of candidate voltages based on the power voltage; generating analysis data including a plurality of state data indicating a state of the storage device by applying each of the plurality of candidate voltages to a host interface that transmits and receives a plurality of packets with the host; transmitting the analysis data to the host; generating, by the host, a selection signal that indicates one of the plurality of candidate voltages as a driving voltage; and driving the host interface with the driving voltage based on the selection signal.

A storage device according to one implementation comprising: a host interface connected to a host and configured to transmit and receive a plurality of packets; a voltage control module configured to generate a plurality of candidate voltages based on a power voltage input through a power port, and generate a power control signal based on a selection signal indicating one of the plurality of candidate voltages; an analysis module configured to generate a plurality of state data indicating the state of the storage device for each of the plurality of candidate voltages; and a power management integrated circuit (PMIC) configured to generate a driving voltage that drives the host interface based on the power control signal.

The methods and devices described herein allow the improved selection of a driving voltage for a host interface, thereby improving power usage efficiency and reducing heat generation while also ensuring appropriate performance.

At least some of the above and other features of the invention are set out in the claims.

### BRIEF DESCRIPTION OF THE DRAWINGS

FIG. 1 is a drawing illustrating a storage system according to an implementation.
FIG. 2 is a drawing illustrating a storage controller according to an implementation.
FIG. 3 is a drawing illustrating a nonvolatile memory according to an implementation.
FIG. 4 is a drawing illustrating an operation method of a storage system according to an implementation.
Fig. 5 is a drawing illustrating the optimal driving voltage search operation according to Fig. 4.
FIG. 6 is a drawing illustrating a step of generating a selection signal according to FIG. 4.
FIG. 7 is a drawing illustrating a storage system according to an implementation.
FIG. 8 is a drawing illustrating a user system applied with a storage system according to an example implementation.
FIG. 9 is a block diagram illustrating a computing system to which a storage system according to an implementation is applied.
FIG. 10 is a block diagram illustrating a computer system according to an implementation.
FIG. 11 is a block diagram illustrating a server system according to an implementation.

### DETAILED DESCRIPTION

In the following detailed description, only certain implementations of the present disclosure have been shown and described, simply by way of illustration. As those skilled in the art will realize, the described implementations may be modified in various different ways, all without departing from the scope of the present disclosure and the appended claims. Accordingly, the drawings and description are to be regarded as illustrative in nature and not restrictive. Like reference numerals designate like elements throughout the specification. In the flowcharts described with reference to the drawings in this specification, the operation order may be changed, various operations may be merged, certain operations may be divided, and/or certain operations may be omitted and not performed. As used herein, the singular forms "a", "an" and "the" are intended to include the plural forms as well, unless the context clearly indicates otherwise. Expressions such as "first" and "second" indicate various constituent elements regardless of order and/or importance, are used for distinguishing a constituent element from another constituent element, and do not limit corresponding constituent elements. For example, a "first" constituent element may be referred to as a "second" constituent element without deviating from the scope described in the present specification, and similarly, a "second" constituent element may be referred to as a "first" constituent element. As used in this specification, a phrase of the form "at least one of A, B, or C" includes within its scope "only A", "only B", "only C", "A and B", "A and C", "B and C" and "A, B, and C."

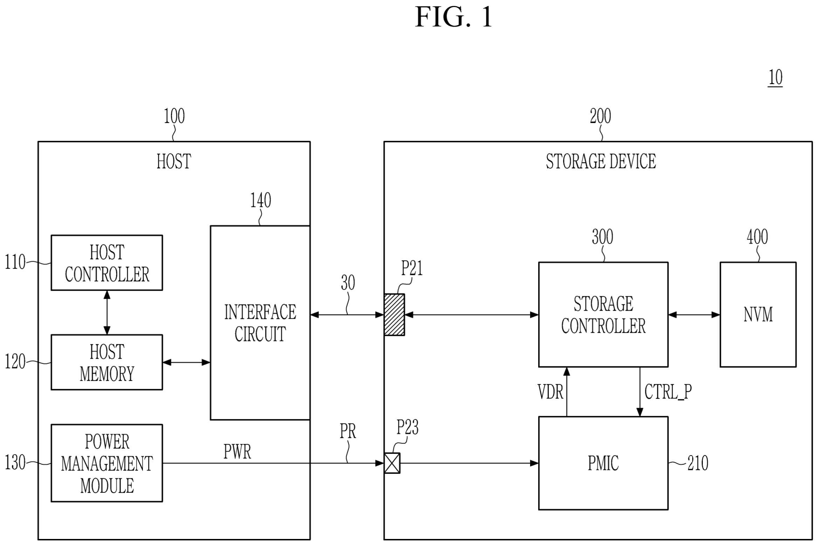

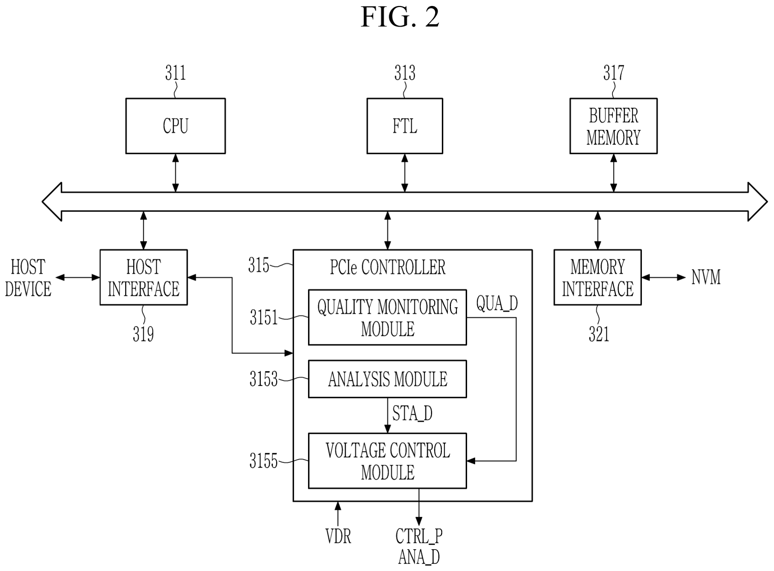

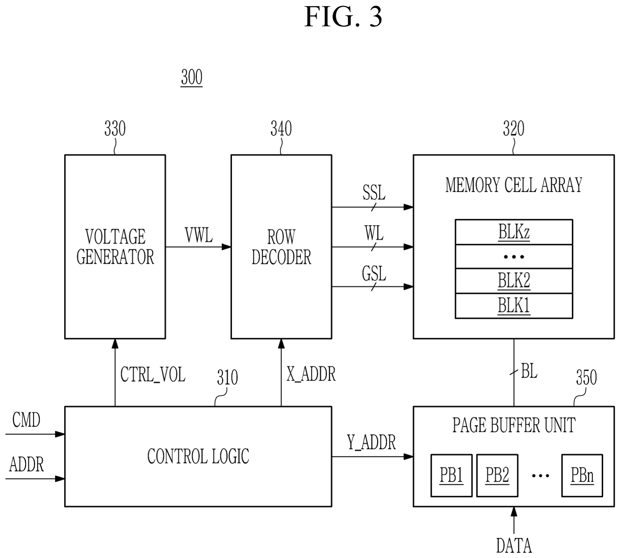

FIG. 1 is a drawing illustrating a storage system according to an implementation. FIG. 2 is a drawing illustrating a storage controller according to an implementation. FIG. 3 is a drawing illustrating a nonvolatile memory according to an implementation.

In one or more implementations, a storage system 10 may be included in user devices such as a personal computer, laptop computer, server, media player, digital camera, or the like, or in automotive devices such as navigation, black box, automotive electronic device. Alternatively, the storage system 10 may be included in a mobile system such as a mobile phone, a smart phone, a tablet personal computer (PC), a wearable device, a healthcare device or an internet of things (loT) device.

As shown in FIG. 1, the storage system 10 includes a host device 100 and a storage device 200.

The host device 100 may control the overall operation of the storage system 10. For example, the host device 100 may store data in the storage device 200 or transmit a request to the storage device 200 to read data stored in the storage device 200. In some implementations, the host device 100 may be a processor core, such as a central processing unit (CPU), an application processor (AP), configured to control the storage system 10, or a computing node connected through a network.

The host device 100 may communicate with the storage device 200. For example, the host 100 may communicate with the storage device 200 through a Peripheral Component Interconnect Express (PCle) interface. Meanwhile, the present disclosure is not limited thereto, and the host 100 may communicate with the storage device 200 through various interfaces such as USB (Universal Serial Bus), MMC (MultiMediaCard), ATA (AT Attachment), SATA (Serial AT Attachment), PATA (Parallel AT Attachment), SCSI (Small Computer System interface), SAS (Serial Attached SCSI), ESDI (Enhanced Small Disk Interface), IDE (Integrated Drive Electronics), NVMe (Non-Volatile Memory Express), etc.

Specifically, the host device 100 may communicate with the storage device 200 through the link 30. For example, the link 30 may correspond to a dual-simplex communication channel between the host device 100 and the storage device 200. The link 30 includes at least one pair of transmission path and reception path, where one pair of transmission path and reception path may be defined as a lane. The link 30 may aggregate a plurality of lanes to expand bandwidth. The number of lanes forming one link may be defined as link width. The data clock used in link 30 may be embedded using several encoding schemes to achieve high interfacing rates (i.e., communication speed). The lanes included in the link 30 may be represented by xN (where N is the width of the lane).

For example, the PCIe method may support Gen 1 to Gen 5. These generations may define different generations of the PCIe technical specification. Gen 1 to Gen 5 may be classified according to data communication speed. Gen 1 may provide 250MB/s per lane, and Gen 2 may provide 500MB/s per lane. Gen 3 may change the encoding scheme from 8b/10b to 128b/130b and provide 984.6MB/s per lane, Gen 4 may provide 1969 MB/s per lane, and Gen 5 may provide 3938MB/s per lane. Meanwhile, lanes supported by PCle may be x1, x2, x4, x8, and x16. In hardware initialization step, the link 30 may be appropriately set according to negotiation of the lane width and operating frequency by the host device 100 and the storage device 200. For example, the link 30 may be set through link number negotiation, lane number negotiation, etc. As the link 30 is set, the communication speed between the host device 100 and the storage device 200 may be determined. Each link may support a symmetrical number of lanes in each direction. For example, an x16 link may have 16 differential signal pairs in each direction.

The host device 100 may include a host controller 110, a host memory 120, a power management module 130, and an interface circuit 140. In some implementations, the host controller 110 and host memory 120 may be implemented as separate semiconductor chips. In some implementations, the host controller 110 and host memory 120 may be integrated on the same semiconductor chip.

The host controller 110 may be a device configured to control overall operations of the host device 100 or the storage device 200. For example, the host controller 110 may control the operation (e.g., operation, logic, control, input/output, etc.) of the host 100. For example, the host controller 110 may be, for example, a central processing unit (CPU), a graphics processing unit (GPU), a microprocessor, or an application processor (AP).

The host controller 110 may include an application layer such as a host operating system (OS), and a protocol layer such as a nonvolatile Memory Express (NVMe).

The host OS may be driven by the host controller 110 and may control a general operation of the host device 100. For example, the host controller 110 may control data processing operations of the storage device 200, that is, a data read operation or a data write operation. The NVMe may be a register-level interface for regulating a method for host software driven by the host device 100 to communicate with the storage device 200 through a peripheral component interconnect express (PCIe) bus. The host controller 110 may be implemented as a general-purpose processor including one or more processor cores, an exclusive processor, or an application processor.

In one implementation, the host controller 110 may transmit a measurement start signal to the storage device 200. The measurement start signal may be a command that controls the storage device 200 to perform an optimal driving voltage search operation. The optimal driving voltage search operation may be an operation of searching for an optimal driving voltage for driving an interface (e.g., a PCIe interface) through which the storage device 200 communicates with the host 100. In one implementation, the measurement start signal may be a vendor unique command. Vendor unique commands may be commands that are limited to specific vendors, such as manufacturers. In one implementation, the measurement start signal may be predetermined in the host device 100 and the storage device 200. In one implementation, the measurement start signal may include data indicating the execution time at which to perform the optimal driving voltage search operation.

The driving voltage may be a voltage (e.g., a power) supplied to a host interface of the storage device 200 (the interface of the storage device 200 with the host 100 on the storage device 200 side). The driving voltage therefore affects signals transmitted by the storage device 200 to the host 100. The driving voltage also affects (indirectly) the quality of signals received by the storage device 200 from the host 100. Accordingly, in one implementation, the storage device 200 generates analysis data for respective candidate driving voltages. The analysis data may be generated by measuring the quality of signals received from the host 100 as the driving voltage is varied. In addition, or alternatively, the analysis data may be generated by measuring the quality of signals transmitted to the host 100 as the driving voltage is varied. The analysis data may be sent to the host controller 110.

In one implementation, as described below, the host controller 110 may receive analysis data from the storage device 200. The host controller 110 may generate a selection signal based on the analysis data. The selection signal may be a signal that indicates the voltage that the storage device 200 applies to a host interface within a storage controller 300 of the storage device 200.

In one implementation, the host controller 110 may generate a selection signal based on the type of storage device 200. For example, the type of the storage device 200 may be determined based on the connection location with the host device 100 (e.g., to which terminal among multiple terminals of the host device 100 the storage device 200 is connected).

For example, when a storage device 200 is connected to a first terminal of a host device 100, the host controller 110 may determine that the type of the storage device 200 is a first type and may generate a selection signal indicating a candidate voltage having the lowest voltage among the received analysis data. Here, the storage device 200 connected to the first terminal may be a device with low importance, and accordingly, the host controller 110 may generate a selection signal that places top priority on voltage efficiency.

For example, when a storage device 200 is connected to a second terminal of a host device 100, the host controller 110 may determine that the type of the storage device 200 is a second type and may generate a selection signal indicating a candidate voltage having status data STA_D (also referred to as state data STA_D in the present disclosure) indicating the highest reliability among the received analysis data. Here, the storage device 200 connected to the second terminal may be a device with high importance, and accordingly, the host controller 110 may generate a selection signal that places top priority (e.g., highest priority) on the data reliability. Meanwhile, the present disclosure is not limited thereto, and the host controller 110 may also generate a selection signal based on various factors.

The host memory 120 may be a buffer memory, cache memory, or operating memory used in the host device 100. For example, the host controller 110 may store write data in the buffer region of the host memory 120 in order to write the write data to the storage device 200. For example, the host controller 110 may read data stored in the storage device 200 and may store the data in the buffer region of the host memory 120. Additionally, various software or data running on the host device 100 may be loaded into the host memory 120.

Host memory 120 may store commands and data executed and processed by the host controller 110. For example, an operating system executed by a host controller 110 may include a file system for file management and a device driver for controlling a peripheral device including a storage device 200 at the operating system level.

In one implementation, host memory 120 may contain data necessary for the host controller 110 to generate a selection signal. For example, the host memory 120 may include data regarding the criteria for generating a selection signal based on the connection location between the host device 100 and the storage device 200.

The power management module 130 may provide power voltage PWR to the storage device 200. For example, the power management module 130 may be implemented as a power management integrated circuit (PMIC).

The host device 100 may communicate with the storage device 200 through the interface circuit 140. Specifically, the interface circuit 140 may receive a control signal generated by the host controller 110 and may transmit the control signal to the storage device 200.

The interface circuit 140 may include a physical layer and/or a logical layer configured to transmit/receive and process data, signals, and/or packets so that the host device 100 may communicate with the storage device 200. For example, the interface circuit 140 may include multiple PCIe ports. A PCIe port may include an NVMe management endpoint, which may be a Management Component Transport Protocol (MCTP) endpoint.

The storage device 200 may operate based on a request received from the host device 100. For example, the storage device 200 may write data to the nonvolatile memory 400 or read data stored in the nonvolatile memory 400 based on the control of the host device 100.

The storage device 200 may include storage media for storing data. For example, the storage device 200 may be implemented in the form of a solid state drive (SSD), a smart SSD, an embedded Multimedia Card (eMMC), an embedded Universal Flash Storage (UFS) memory device, a UFS memory card, a Compact Flash (CF), a Secure Digital (SD), a Micro Secure Digital (Micro-SD), a Mini Secure Digital (Mini-SD), an xD (extreme Digital), a Memory Stick, or a similar form.

The storage device 200 may include a PMIC 210, a storage controller 300, and non-volatile memory 400.

PMIC 210 may receive power voltage PWR from power management module 130 through power port P23. The storage device 200 may receive power voltage PWR from the host device 100 through a power rail PR and a power port P23. In one implementation, the PMIC 210 may generate a driving voltage VDR required for operation of the storage device 200 based on a power supply voltage PWR. In one implementation, the PMIC 210 may receive a power control signal CTRL_P from the storage controller 300. PMIC 210 may generate a driving voltage VDR based on a power control signal CTRL_P. The power voltage PWR supplied to the storage device 200 may be distributed to other components (e.g., a storage controller 300 and a nonvolatile memory device 400) through the internal power rail of the storage device 200.

In Fig. 1, the power port P23 is illustrated as being one, but the present disclosure is not limited thereto, and the PMIC 210 may receive multiple power voltages from the host device 100 through multiple power lines.

The storage controller 300 may control the operation of the storage device 200. For example, the storage controller 300 may perform various management operations to efficiently use the non-volatile memory 400. The storage controller 300 may provide signals (e.g., address ADDR, command CMD, control signal CTRL of FIG. 3) for controlling nonvolatile memory 400 in response to request signals received from the host device 100. That is, the storage controller 300 may provide signals to the nonvolatile memory 400 to write data into the nonvolatile memory 400 or read data from the nonvolatile memory 400. The storage controller 300 and non-volatile memory 400 may exchange data DATA.

In one implementation, the storage controller 300 may include a central processing unit (CPU), a controller, and/or an application specific integrated circuit (ASIC).

In one implementation, the storage controller 300 may receive a driving voltage VDR from the PMIC 210.

In one implementation, the storage controller 300 may perform an optimal driving voltage search operation. The optimal driving voltage search operation may be an operation to determine the optimal driving voltage for driving a link 30 (e.g., a PCIe interface) communicating with a host device 100. For example, the storage controller 300 may perform an optimal driving voltage search operation when the storage device 200 is connected to the host device 100 and receives a power voltage PWR or receives a measurement start signal from the host device 100.

Referring to FIG. 2 together, the storage controller 300 may include a CPU 311, a Flash Translation Layer (FTL) 313, a PCle controller 315, a buffer memory 317, a host interface 319, and a memory interface 321.

The CPU 311 may control overall operations of the storage controller 300. The CPU 311 may perform various memory management operations of the storage device 200.

For example, the CPU 311 may control the FTL 313, the PCle controller 315, the buffer memory 317, and the memory interface 321 to write data to the non-volatile memory 400 in response to a request received from the host device 100. Specifically, the CPU 311 may control the memory interface 321 to transmit write data to the non-volatile memory 400. Meanwhile, FTL 313 may perform address mapping the logical address of the host device 100 to the physical address of the non-volatile memory 400 and generate mapping data. Mapping data may be buffered in buffer memory 317.

Meanwhile, the CPU 311 may control the operation of the PCIe controller 315 so that the PCIe controller 315 performs an optimal driving voltage search operation based on a measurement start signal received from the host device 100. The CPU 311 may control the operation of the PCIe controller 315 based on a selection signal received from the host device 100.

FTL 313 may perform various maintenance operations to efficiently use non-volatile memory 400.

Specifically, FTL 313 may perform several functions such as address mapping, wear-leveling, and garbage collection. The address mapping operation may be an operation that changes a logical address received from a host device 100 into a physical address used to actually store data in non-volatile memory 400. Wear leveling may be an operation that prevents excessive deterioration of a specific block by uniformly using the blocks within the nonvolatile memory 400 and uniformly adjusting the frequency or number of times of use of multiple memory blocks included in the nonvolatile memory 400. Garbage collection may be an operation to secure available space in the non-volatile memory 400 by copying valid data from a block to a new block and then erasing the original block.

In one implementation, FTL 313 may be implemented in software or hardware form. When FTL 313 is implemented in software form, program code or information related to FTL 313 may be stored in buffer memory 317 and executed by CPU 311. When FTL 313 is implemented in hardware form, a hardware accelerator configured to perform the operation of FTL 313 may be provided separately from the CPU 311.

The PCIe controller 315 may manage the PCIe interface between the host device 100 and the storage device 200. The PCIe controller 315 may control the voltage applied to the PCIe interface.

In one implementation, the PCIe controller 315 may include a quality monitoring module 3151, an analysis module 3153, and a voltage control module 3155.

The quality monitoring module 3151 may generate quality data QUA_D indicating the quality of signal(s) transmitted and received on a channel (i.e., link 30) based on the voltage applied to the host interface 319. Quality data (QUA_D) may indicate the degree to which a signal is attenuated. A signal transmitted from a host device 100 may be attenuated due to the influence of the channel, and the host interface 319 may receive the attenuated signal. For example, a signal transmitted from a host device 100 may have a higher attenuation of its high frequency components than its low frequency components due to the influence of the channel.

In one implementation, the quality monitoring module 3151 may generate quality data QUA_D using an Eye Open Monitor (EOM). EOM may be an operation in which a device (e.g., the storage device 200 or the host device 100) measures the quality of a signal under specific offset conditions. The EOM may be performed by a transmitter to measure the quality of a transmitted signal, or by a receiver to measure the quality of a received signal. For example, the quality monitoring module 3151 may measure the eye of a signal transmitted by the storage device 200 (e.g., by the host interface 319) to the host device 100. In addition or alternatively, the quality monitoring module 3151 may measure the eye of a signal received at the signal receiving end in the host interface 319. In addition or alternatively, the host device 100 may measure the eye of a signal transmitted by the host device 100 to the host interface 319. In addition or alternatively, the host device 100 may measure the eye of a signal received from the host interface 319. The host device 100 may communicate any quality measurements it makes to the quality monitoring module 3151. During EOM, the quality of a received signal may be determined based on the openness of an eye diagram of the signal. This may be based on horizontal eye opening, vertical eye opening and/or mask violations.

The quality monitoring module 3151 may transmit quality data QUA_D corresponding to the voltage applied to the host interface 319 to the voltage control module 3155.

The analysis module 3153 may generate status data STA_D by measuring the status of the storage device 200 as voltage is applied to the host interface 319. In one implementation, the status data STA_D may include information about the speed (e.g., Gen3, Gen4, Gen5, etc.), bandwidth, reliability, latency, and physical connection status of the PCIe interface of the storage device 200.

For example, the bandwidth of a PCIe interface may include information about the number of lanes (e.g., x2, x4, x8, x16 lanes, etc.) between the storage device 200 and the host device 100. For example, the physical connection state of a PCIe interface may include information such as whether lane reversal has occurred or whether there is a reduction in lane width, etc. For example, the reliability of a PCIe interface may include information about the number of errors (PHY error count) that occur during data transmission between a storage device 200 and a host device 100, the number of times (Nack count) the storage device 200 fails to receive data and requests retransmission to the host device 100, etc. For example, information about latency may include information about the maximum size of read request data that the storage device 200 may request from the host device 100 at one time (Max Read Request Size, MRRS), the maximum size of payload that may be transmitted between the storage device 200 and the host device 100 at one time (Max Payload Size, MPS), etc.

The analysis module 3153 may transmit status data STA_D corresponding to the voltage applied to the host interface 319 to the voltage control module 3155.

The voltage control module 3155 may control the driving voltage applied to the host interface 319. The voltage control module 3155 may generate a power control signal CTRL_P. The voltage control module 3155 may generate a power control signal CTRL_P that controls the PMIC 210 to apply a driving voltage to the host interface 319.

In one implementation, the voltage control module 3155 may generate a plurality of candidate voltages to be applied to the host interface 319 based on the power supply voltage PWR. The voltage control module 3155 may control the quality monitoring module 3151 and the analysis module 3153 so that the quality monitoring module 3151 and the analysis module 3153 may generate quality data QUA_D and status data STA_D corresponding to each of a plurality of candidate voltages.

In one implementation, the number of candidate voltages may be predetermined. The plurality of candidate voltages may be a set of voltages that decrease by constant voltage difference relative to a predetermined initial setting voltage corresponding to the storage device 200. For example, the plurality of candidate voltages can be a sequence of candidate voltages that have a constant voltage difference between adjacent candidate voltages. A maximum voltage of the sequence of candidate voltages is equal to a predetermined initial setting voltage that corresponds to the storage device (e.g., based on a type of the storage device, or an importance level of the storage device). In some implementations, the sequence of candidate voltages can be ranked from a high voltage (e.g., the predetermined initial setting voltage) to a low voltage.

In one implementation, the voltage control module 3155 may determine the number of candidate voltages based on the execution time within the measurement start signal received from the host device 100. For example, if the execution time is set to 60 seconds, and it is assumed that the time taken by the quality monitoring module 3151 to generate quality data QUA_D for each candidate voltage and the time taken by the analysis module 3153 to generate status data STA_D for each candidate voltage are 10 seconds, a total of 6 candidate voltages may be generated. That is, the voltage control module 3155 may determine the number of plurality candidate voltages based on the execution time and the time to measure quality data QUA_D and status data STA_D for one candidate voltage.

In one implementation, the voltage control module 3155 may generate analysis data ANA_D including a plurality of candidate voltages and state data STA_D corresponding to the plurality of candidate voltages. For example, the voltage control module 3155 may generate a power control signal CTRL_P that applies a first candidate voltage among a plurality of candidate voltages to the host interface 319. The quality monitoring module 3151 may generate first quality data QUA_D for the first candidate voltage. The analysis module 3153 may generate first state data STA_D for the first candidate voltage. The voltage control module 3155 may generate analysis data ANA_D including a first candidate voltage and first state data STA_D when the first quality data QUA_D satisfies a predetermined quality criterion. Thereafter, the voltage control module 3155 may generate a power control signal CTRL_P that controls the PMIC 210 to apply a second candidate voltage among the plurality of candidate voltages to the host interface 319. The quality monitoring module 3151 may generate second quality data QUA_D for the second candidate voltage. The analysis module 3153 may generate second state data STA_D for the second candidate voltage. The second candidate voltage is smaller than the first candidate voltage. The voltage control module 3155 may perform an operation of generating analysis data ANA_D for each of a plurality of candidate voltages, starting from a highest candidate voltage and proceed to a lower candidate voltage, until the second quality data QUA_D does not satisfy a predetermined quality criterion. That is, the voltage control module 3155 may determine that only some candidate voltages that satisfy predetermined quality criteria among plurality of candidate voltages are valid candidate voltages. The voltage control module 3155 may transmit analysis data ANA_D including a valid candidate voltage and status data STA_D corresponding to the valid candidate voltage to the host device 100.

In one implementation, the voltage control module 3155 may transmit analysis data ANA_D to the host device 100.

The voltage control module 3155 may determine the driving voltage based on a selection signal from the host device 100.

The buffer memory 317 may buffer various data used in the operation of the storage device 200. In some implementations, the buffer memory 317 may buffer metadata. For example, the metadata may include mapping data referenced to perform conversion between an address provided from a host device 100 and a physical address on a nonvolatile memory 400, ECC (Error Correction Code) data referenced to detect and correct errors in data output from a nonvolatile memory 400, status data related to the status of each nonvolatile memory 400, etc. For example, the buffer memory 317 may include volatile memory such as SRAM, DRAM, SDRAM, etc., and/or nonvolatile memory such as PRAM, MRAM, ReRAM, FRAM, etc.

The host interface 319 may transmit and receive a plurality of packets with the host device 100. In some implementations, the host interface 319 may be a PCI express (PCle) interface. Meanwhile, the present disclosure is not limited thereto, and the host interface 319 may communicate with the host device 100 according to at least one of various interface protocols, such as an ATA (Advanced Technology Attachment) interface, a SATA (Serial ATA) interface, an e-SATA (external SATA) interface, a SCSI (Small Computer Small Interface) interface, a SAS (Serial Attached SCSI) interface, a PCI (Peripheral Component Interconnection) interface, an NVMe (NVM express) interface, an IEEE 1394, a USB (universal serial bus) interface, an SD (secure digital) card, an MMC (multi-media card) interface, an eMMC (embedded multi-media card) interface, a UFS (Universal Flash Storage) interface, an eUFS (embedded Universal Flash Storage) interface, a CF (compact flash) card interface, or a network interface.

A packet transmitted from the host device 100 to the host interface 319 may include a command or data to be written to a non-volatile memory 400. A packet transmitted from the host interface 319 to the host device 100 may include a response to a command or data read from a non-volatile memory 400.

The memory interface 321 may provide signal transmission and reception with the nonvolatile memory 400. In some implementations, the memory interface 321 may communicate with the nonvolatile memory 400 via at least one of various interface protocols, such as a toggle interface, an ONFI interface, etc.

The memory interface 321 may transmit command and control signals together with data to be written into the nonvolatile memory 400 to the nonvolatile memory 400, or receive data read from the nonvolatile memory 400.

The nonvolatile memory 400 may include a plurality of dies or a plurality of chips including a memory cell array. For example, the nonvolatile memory 400 may include a plurality of chips, and each of the plurality of chips may include a plurality of dies. In some implementations, the nonvolatile memory (400) may also include multiple channels, each channel including multiple chips.

Non-volatile memory 400 may include NAND flash memory. In another implementation, the nonvolatile memory 400 may include Electrically Erasable Programmable Read-Only Memory (EEPROM), Phase Change Random Access Memory (PRAM), Resistive RAM (ReRAM), Resistance Random Access Memory (RRAM), Nano Floating Gate Memory (NFGM), Polymer Random Access Memory (PoRAM), Magnetic Random Access Memory (MRAM), Ferroelectric Random Access Memory (FRAM), or similar memory. Hereinafter, in the present disclosure, it will be described assuming that the nonvolatile memory 400 is a NAND flash memory device.

Referring to FIG. 3 together, the nonvolatile memory 400 may include a control logic 310, a memory cell array 320, a page buffer unit 350, a voltage generator 330, and a row decoder 340.

Control logic 310 may control various operations within the nonvolatile memory 400. The control logic 310 may output various control signals in response to the command CMD and/or the address ADDR from the memory interface circuit 321. For example, the control logic 310 may output a voltage control signal CTRL_vol, a row address X-ADDR, and a column address Y-ADDR.

The memory cell array 320 may include a plurality of memory blocks BLK1 to BLKz (z is a positive integer), and each of the plurality of memory blocks BLK1 to BLKz may include a plurality of memory cells. The memory cell array 320 may be connected to the page buffer unit 350 through a plurality of bit lines BL, and may be connected to the row decoder 340 through wordlines WL, string selection lines SSL, and ground selection lines GSL.

In an implementation, the memory cell array 320 may include a three-dimensional (3D) memory cell array, and the three-dimensional memory cell array may include a plurality of NAND strings. Each NAND string may include memory cells connected to wordlines vertically stacked on a substrate, respectively. In an implementation, the memory cell array 320 may include a two-dimensional (2D) memory cell array, and the two-dimensional memory cell array may include a plurality of NAND strings disposed along row and column directions.

The page buffer unit 350 may include a plurality of page buffers PB1 to PBn (n is an integer of 3 or more), and the plurality of page buffers PB1 to PBn may be connected to the memory cells through the plurality of bit lines BL, respectively. The page buffer unit 350 may select at least one bit line of the plurality of bit lines BL in response to the column address Y-ADDR. The page buffer unit 350 may operate as a write driver or a sense amplifier depending on an operation mode. For example, during a program operation, the page buffer unit 350 may apply, to the selected bit line, a bit line voltage corresponding to data to be programmed. During a read operation, the page buffer unit 350 may detect data stored in a corresponding memory cell by detecting current or voltage of the selected bit line.

The voltage generator 330 may generate various types of voltages for performing the program, read, and erase operations based on the voltage control signal CTRL_vol. For example, the voltage generator 330 may generate a program voltage, a read voltage, a program verification voltage, an erase voltage, and/or the like as wordline voltage VWL.

The row decoder 340 may select one of a plurality of wordlines WL in response to the row address X-ADDR, and select one of a plurality of string selection lines SSL. For example, during program operation, the row decoder 340 may apply the program voltage and the program verification voltage to the selected wordline, and during a read operation, may apply the read voltage to the selected wordline.

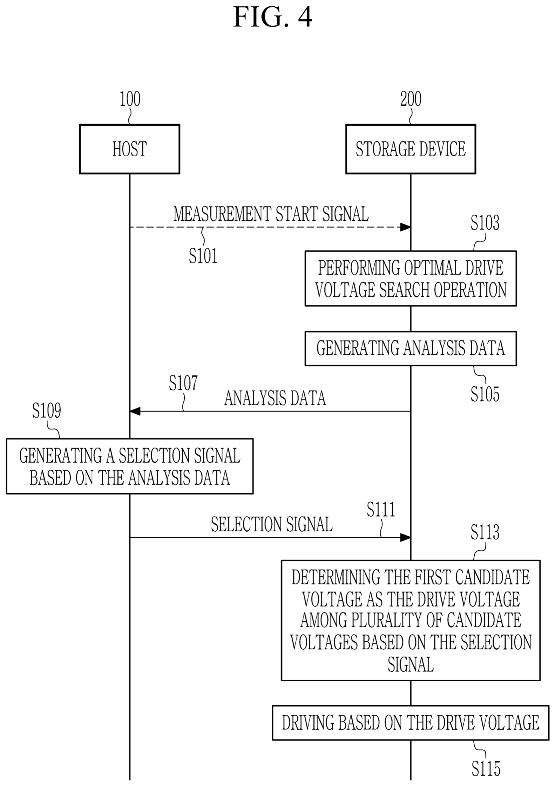

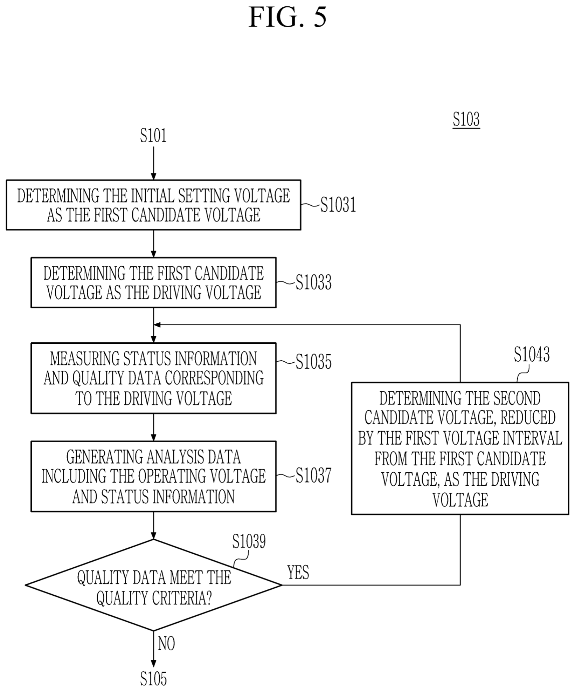

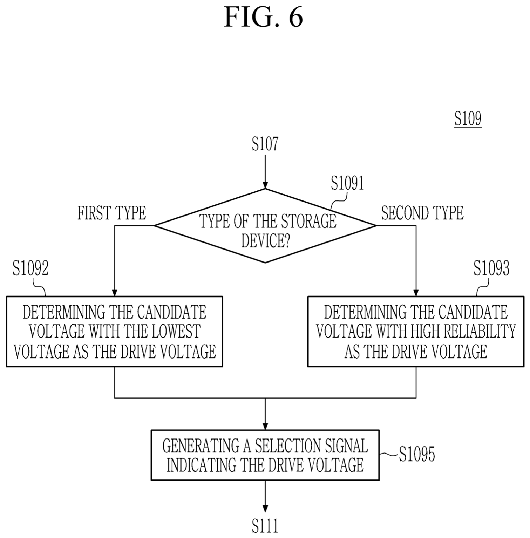

FIG. 4 is a diagram illustrating an operation method of a storage system according to one implementation. Fig. 5 is a diagram illustrating the optimal driving voltage search operation according to Fig. 4. FIG. 6 is a diagram illustrating a step of generating a selection signal according to FIG. 4.

The host 100 transmits a measurement start signal to the storage device 200 (S101).

In one implementation, the measurement start signal may include data indicating the execution time at which the storage device 200 performs an optimal driving voltage search operation.

The storage device 200 performs an optimal driving voltage search operation (S103).

In one implementation, the storage device 200 may perform an optimal driving voltage search operation based on receiving a measurement start signal. Specifically, the voltage control module 3155 may perform an optimal driving voltage search operation. The optimal driving voltage search operation may be an operation to search for candidate voltages of possible driving voltages.

Meanwhile, the present disclosure is not limited thereto, and the storage device 200 may perform an optimal driving voltage search operation based on receiving a power voltage PWR from the host device 100.

Referring to FIG. 5, first, the storage device 200 determines the initial setting voltage as the first candidate voltage (S1031).

The initial setting voltage may be predetermined corresponding to the storage device 200. For example, the initial setting voltage may be the maximum voltage to drive the host interface 319.

The storage device 200 determines the first candidate voltage as the driving voltage (S1033).

The voltage control module 3155 may generate a power control signal CTRL_P that controls the PMIC 210 to apply the first candidate voltage as a driving voltage to the host interface 319.

The storage device 200 measures status data STA_D and quality data QUA_D corresponding to the driving voltage (S1035).

The quality monitoring module 3151 may generate quality data QUA_D indicating the quality of a signal transmitted and received on the link 30 as the first candidate voltage is applied to the host interface 319. Quality data QUA_D may indicate the degree to which a signal is attenuated. The analysis module 3153 may generate status data STA_D by measuring the status of the storage device 200 as the first candidate voltage is applied to the host interface 319.

The storage device 200 generates analysis data ANA_D including driving voltage and status data STA_D (S1037).

The voltage control module 3155 may receive quality data QUA_D from the quality monitoring module 3151 and status data STA_D from the analysis module 3153. The voltage control module 3155 may generate analysis data ANA_D including a driving voltage and status data STA_D corresponding to the driving voltage based on the received quality data QUA_D and status data STA_D.

The storage device 200 determines whether the quality data QUA_D satisfies the quality criteria (S1039).

Quality criteria may be predetermined. For example, the quality criteria may set a predefined (e.g., maximum) threshold for signal attenuation. For example, a quality criterion may be set when the transmitted or received signal is attenuated by more than 10%. For example, the quality criterion may be met if the signal attenuation is less than or equal to 10%. The power control module 3155 may determine that the storage device 200 satisfies the quality criterion if the quality data QUA_D indicates that the signal attenuation is 5%. On the other hand, the power control module 3155 may determine that the storage device 200 does not satisfy the quality criterion if the quality data QUA_D indicates that the signal attenuation is 20%.

If the quality data QUA_D satisfies the quality criterion, the storage device 200 determines the second candidate voltage, which is reduced by a first voltage interval from the first candidate voltage, as the driving voltage (S1043).

In one implementation, the number of candidate voltages may be precalculated based on the measurement start signal. Based on the number of candidate voltages, a first voltage interval between the candidate voltages may be predetermined.

In one implementation, the first voltage interval may be set based on a measurement start signal.

Subsequently, the storage device 200 performs S1035. That is, in response to the quality data QUA_D meeting the quality criteria, the candidate voltage is reduced by the first voltage interval and steps S1035-S1039 are repeated.

Referring again to FIG. 4, if the quality data QUA_D does not satisfy the quality criteria, the storage device 200 generates analysis data ANA_D (S105).

Specifically, the analysis module 3153 may generate status data STA_D by measuring the status of the storage device 200 as voltage is applied to the host interface 319. In one implementation, the status data STA_D may include information about the speed, bandwidth, reliability, latency, and physical connection status of the PCIe interface of the storage device 200. The analysis module 3153 may transmit voltage and corresponding status data STA_D to the voltage control module 3155. The voltage control module 3155 may generate analysis data ANA_D. In one implementation, the voltage control module 3155 may generate analysis data ANA_D including a valid candidate voltage satisfying a quality criterion and status data STA_D corresponding to the valid candidate voltage.

The storage device 200 transmits analysis data ANA_D to the host device 100 (S107).

The host device 100 generates a selection signal based on analysis data ANA_D (S109).

The selection signal may be a signal indicating a voltage to be applied to the host interface 319.

Referring to FIG. 6, first, the host device 100 determines the type of the storage device (S1091).

In one implementation, the host device 100 may generate a selection signal based on the type of storage device 200. For example, the type of storage device 200 may be determined based on its connection location with the host device 100.

If the storage device 200 is of the first type, the host device 100 determines the candidate voltage having the lowest voltage as the driving voltage (S1092).

If the storage device 200 is of the second type, the host device 100 determines a candidate voltage with high reliability as the driving voltage (S1093). For instance, a candidate voltage that is associated with analysis data that indicates high reliability may be selected. High reliability may be relative to the reliability of other (e.g., lower) candidate voltages. For instance, a reliability criterion (e.g., a predefined threshold) may be set for each of one or more parameters in the analysis data. A candidate voltage may be deemed to have high reliability if the analysis data indicates that, for each of the one or more parameters, the reliability criterion is met.

The host device 100 generates a selection signal indicating the driving voltage (S1095).

Referring again to FIG. 4, the host device 100 transmits a selection signal to the storage device 200 (S111).

The storage device 200 determines a first candidate voltage among a plurality of candidate voltages as a driving voltage based on a selection signal (S113).

The storage device 200 is driven based on the driving voltage (S115).

Specifically, the storage device 200 may drive the host interface 319 with a driving voltage determined based on the selection signal. The voltage control module 3155 may determine a driving voltage based on (e.g., indicated by) a selection signal and may generate a power control signal CTRL_P that controls the PMIC 210 so that the determined driving voltage is applied to the host interface 319.

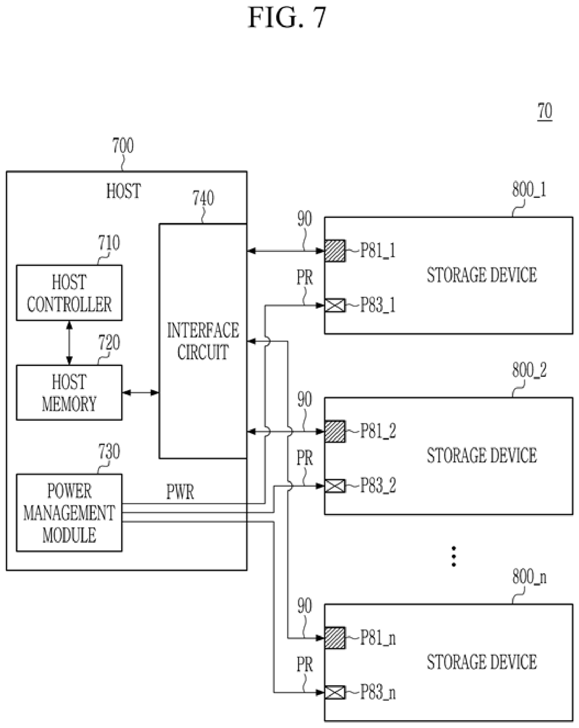

FIG. 7 is a diagram illustrating a storage system according to one implementation.

The storage system 70 may include a host 700 and a plurality of storage devices 800_1, 800_2, ..., 800_n. The power management module 730 of the host device 100 may provide power voltage PWR to multiple storage devices 800_1, 800_2, ..., 800_n.

The host 700 may include a host controller 710, host memory 720, a power management module 730, and an interface circuit 740. Unless otherwise stated, the description of the host device 100 described with reference to FIG. 1 may equally be applied to the host 700.

As illustrated in FIG. 7, the interface circuit 740 may include a plurality of terminals. The plurality of storage devices 800_1, 800_2, ..., 800_n may transmit and receive data through terminals P81_1, P81_2, ..., P81_n.

The host 700 is connected to the first storage device 800_1 through a first terminal of the interface circuit 740 and a first terminal P81_1 of the first storage device 800_1 and may transmit and receive data. The host 700 is connected to the nth storage device 800_n through a second terminal of the interface circuit 740 and an nth terminal P81_n of the nth storage device 800_n, and may transmit and receive data. The host 700 is connected to the second storage device 800_2 through the nth terminal of the interface circuit 740 and a second terminal P81_2 of the second storage device 800_2 and may transmit and receive data.

The plurality of storage devices 800_1, 800_2, ..., 800_n may receive power voltage PWR from the host 700 through power rails PR and power ports P83_1, P83_2, ..., P83_n connected to each storage device.

Each of the plurality of storage devices 800_1, 800_2, ..., 800_n may receive a power voltage PWR from the host 700 and generate a plurality of candidate voltages.

Each of the plurality of storage devices 800_1, 800_2, ..., 800_n may generate a plurality of state data STA_D indicating the state of the storage device corresponding to each of the plurality of candidate voltages. Each of the plurality of storage devices 800_1, 800_2, ..., 800_n may transmit analysis data ANA_D including a plurality of candidate voltages and a plurality of state data STA_D corresponding to the plurality of candidate voltages to the host 700.

The host 700 may generate a selection signal based on the type of each of the plurality of storage devices 800_1, 800_2, ..., 800_n. For example, the host 700 may generate a selection signal based on the connection location of each of the plurality of storage devices 800_1, 800_2, ..., 800_n. For example, the host 700 may determine that a storage device connected to the first terminal is important for reliability, a storage device connected to the second terminal is important for speed, and a storage device connected to the nth terminal is important for voltage consumption. Accordingly, the host 700 may generate a selection signal based on the type of each of the plurality of storage devices 800_1, 800_2, ..., 800_n. The host 700 may transmit a selection signal corresponding to each of a plurality of storage devices 800_1, 800_2, ..., 800_n.

Each of the plurality of storage devices 800_1, 800_2, ..., 800_n may determine one of the plurality of candidate voltages as a driving voltage based on a selection signal, and apply the driving voltage to a PCIe interface between the host 700 and the storage device 200.

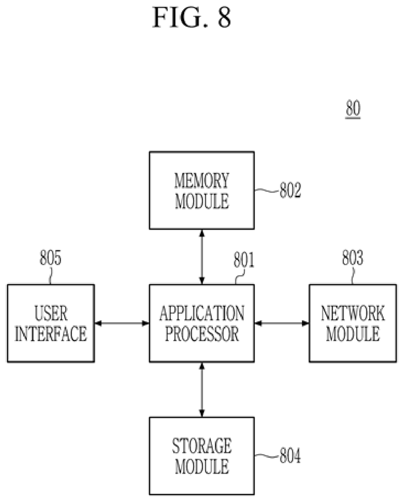

FIG. 8 is a drawing illustrating a user system applied with a storage system according to an example implementation.

Referring to FIG. 8, a user system 80 includes an application processor 801, a memory module 802, a network module 803, a storage module 804, and a user interface 805.

The application processor 801 may drive components included in the user system 80 and an operating system (OS). For example, the application processor 801 may include controllers, interfaces, graphic engines, and/or the like for controlling components included in the user system 80. The application processor 801 may be provided as a system-on-chip (SoC).

For example, the application processor 801 may be a host device (100 of FIG. 1) described with reference to FIGS. 1 to 7.

The memory module 802 may operate as a main memory, an operating memory, a buffer memory, or a cache memory of the user system 80. The memory module 802 may include a volatile random-access memory such as a DRAM, a synchronous DRAM (SDRAM), a double data rate (DDR) SDRAM, a DDR2 SDRAM, a DDR3 SDRAM, a low-power DDR (LPDDR) SDARM, an LPDDR3 SDRAM, an LPDDR3 SDRAM, and/or the like or a non-volatile random-access memory such as PRAM, ReRAM, MRAM, FRAM.

The network module 803 may perform communication with external devices. For example, the network module 803 may support wireless communication such as code-division multiple access (CDMA), Global System for Mobile Communication (GSM), wideband CDMA (WCDMA), CDMA-2000, Time Division Multiple Access (TDMA), long term evolution (LTE), Wimax, WLAN, UWB, Bluetooth, WI-DI. In an implementation, the network module 803 may be included in the application processor 801.

The storage module 804 may store data. For example, the storage module 804 may store data received from the application processor 801. Alternatively, the storage module 804 may transmit data stored in the storage module 804 to the application processor 801. By way of an example, the storage module 804 may be implemented as a non-volatile semiconductor memory device such as a phase-change RAM (PRAM), a magnetic RAM (MRAM), a resistive RAM (RRAM), a NAND flash, a NOR flash, a three-dimensional NAND flash, and/or the like.

By way of an example, the storage module 804 may correspond to a storage device (e.g., 200 of FIG. 1) described with reference to FIG. 1 to FIG. 7.

The storage module 804 may generate multiple candidate voltages based on a power voltage input from an external source. The storage module 804 may generate analysis data including a plurality of state data indicating the state of the storage module 804 by applying each of a plurality of candidate voltages to a host interface that transmits and receives a plurality of packets with the host. The storage module 804 may transmit analysis data to the host. The storage module 804 may drive the host interface with a driving voltage determined based on the analysis data. Accordingly, the storage module 804 may have the effect of maximizing power usage efficiency, reducing heat generation, and dynamically setting the voltage of the host interface.

The user interface 805 may include interfaces that input data or commands in the application processor 801 and/or output data to external devices. By way of an example, the user interface 805 may include user input interfaces such as a keyboard, a keypad, a button, a touch panel, a touch screen, a touch pad, a touch ball, a camera, a microphone, a gyroscope sensor, a vibration sensor, a piezoelectric element, and/or the like. The user interface 805 may include user output interfaces such as a liquid-crystal display (LCD), an organic light-emitting diode (OLED) display device, an active matrix OLED (AMOLED) display device, an LED, a speaker, a motor, and/or the like.

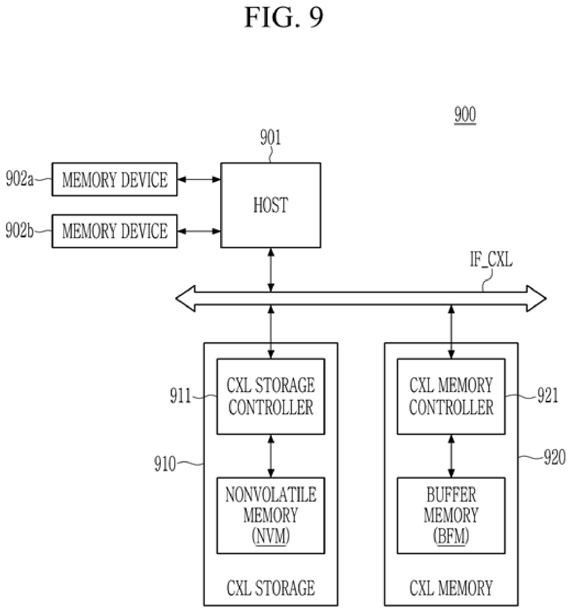

FIG. 9 is a block diagram illustrating a computing system to which a storage system according to one implementation is applied.

Referring to FIG. 9, a computing system 900 may include a host 901, a plurality of memories 902a, 902b, CXL storage 910, and CXL memory 920.

In one implementation, the computing system 900 may be included in user devices such as a personal computer, a laptop computer, a server, a media player, a digital camera, or an automotive device such as a navigation, a black box, or an automotive electrical device. Alternatively, the computing system 900 may be a mobile system such as a mobile phone, a smart phone, a tablet personal computer, a wearable device, a healthcare device, or an Internet of Things (IoT) device.

The host 901 may control all operations of the computing system 901. In one implementation, the host 901 may be one of various processors, such as a central processing unit (CPU), a graphics processing unit (GPU), a neural processing unit (NPU), a data processing unit (DPU), and the like. In one implementation, the host 901 may include a single core processor or a multi-core processor.

In one implementation, the host 901 may be a host (100 of FIG. 1) described with reference to FIGS. 1 to 7.

The plurality of memory devices 902a, 902b may be used as main memory or system memory of the computing system 900. In one implementation, each of the plurality of memory devices 902a, 902b may be a dynamic random access memory (DRAM) device and may have a form factor of a dual in-line memory module (DIMM). However, the present disclosure is not limited thereto, and the plurality of memory devices 902a, 902b may include nonvolatile memory such as flash memory, PRAM, RRAM, MRAM, etc.

The plurality of memory devices 902a, 902b may communicate directly with the host 901 thorugh a DDR interface. In one implementation, the host 901 may include a memory controller configured to control a plurality of memory devices 902a, 902b. However, the present disclosure is not limited thereto, and a plurality of memory devices 902a, 902b may communicate with the host 901 through various interfaces.

The CXL storage 910 may include a CXL storage controller 911 and non-volatile memory NVM. The CXL storage controller 911 may store data in a nonvolatile memory NVM or transmit data stored in a nonvolatile memory NVM to the host 901 under the control of the host 901. In one implementation, the non-volatile memory NVM may be NAND flash memory, although the present disclosure is not limited thereto.

The CXL memory 920 may include a CXL memory controller 921 and a buffer memory BFM. The CXL memory controller 921 may store data in the buffer memory BFM or transmit data stored in the buffer memory BFM to the host 901 under the control of the host 901. In one implementation, the buffer memory BFM may be DRAM, although the present disclosure is not limited thereto.

In one implementation, the host 901, CXL storage 910, and CXL memory 920 may be configured to share the same interface with each other. For example, the host 901, CXL storage 910, and CXL memory 920 may communicate with each other through a CXL interface IF_CXL. In one implementation, the Compute Express Link interface IF_CXL may refer to a low-latency, high-bandwidth link that supports dynamic protocol muxing of coherency, memory access, and input/output (IO) protocols to enable a variety of connections between accelerators, memory devices, or various electronic devices.

In one implementation, the CXL storage 910 may not include separate buffer memory for storing or managing map data. In this case, the CXL storage 910 may require buffer memory to store or manage map data. In one implementation, at least a portion of the CXL memory 920 may be used as buffer memory of the CXL storage 910. In this case, a mapping table managed by the CXL storage controller 911 of the CXL storage 910 may be stored in the CXL memory 920. For example, at least a portion of the CXL memory 920 may be allocated by the host 901 as buffer memory of the CXL storage 910 (i.e., a dedicated area for the CXL storage 910).

In one implementation, CXL storage 910 may access CXL memory 920 through a CXL interface IF_CXL. For example, the CXL storage 910 may store a mapping table in an allocated area of the CXL memory 920 or read out a stored mapping table. The CXL memory 920 may store data (e.g., map data) in the buffer memory BFM or transmit data (e.g., map data) stored in the buffer memory BFM to the CXL storage 910 under the control of the CXL storage 910.

In one implementation, the CXL storage 910 may be a storage device (200 of FIG. 1) described with reference to FIGS. 1 to 7.

The CXL storage 910 may generate a plurality of candidate voltages based on a power voltage input from an external source. The CXL storage 910 may generate analysis data including a plurality of state data indicating the state of the CXL storage 910 by applying each of a plurality of candidate voltages to a CXL interface IF_CXL that transmits and receives a plurality of packets with the host. CXL storage 910 may transmit analysis data to the host 901. The CXL storage 910 may drive the CXL interface IF_CXL with a driving voltage determined based on analysis data. Accordingly, the CXL storage 910 may have the effect of maximizing power usage efficiency, reducing heat generation, and dynamically setting the voltage of the CXL interface IF_CXL.

On the other hand, according to an implementation of the present disclosure, the CXL storage controller 911 of the CXL storage 910 may communicate with the host 901 and the CXL memory 920 (i.e., buffer memory) through the CXL interface IF_CXL. In other words, the CXL storage controller 911 of the CXL storage 910 may communicate with the host 901 and the CXL memory 920 through a homogeneous interface or a common interface, and may use a part of the CXL memory 920 as a buffer memory.

Hereinafter, for convenience of explanation, it is assumed that the host 901, CXL storage 910, and CXL memory 920 communicate with each other through the CXL interface IF_CXL. However, the present disclosure is not limited thereto, and the host 901, CXL storage 910, and CXL memory 920 may communicate with each other based on various computing interfaces such as the GEN-Z protocol, the NVLink protocol, the CCIX protocol, the Open CAPI protocol, and the like.

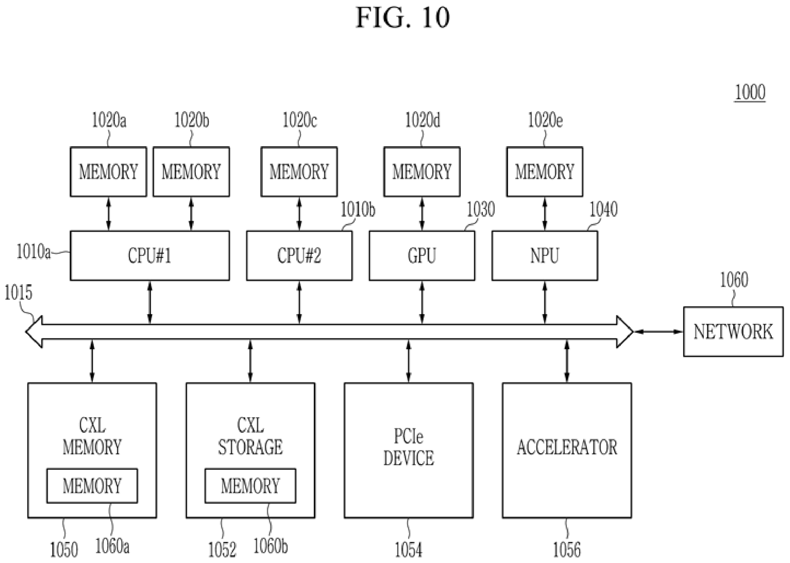

FIG. 10 illustrates a block diagram of a computer system, according to an implementation.

Referring to FIG. 10, a computer system 1000 may include a first CPU 1010a, a second CPU 1010b, a GPU 1030, an NPU 1040, a CXL switch 1015, a CXL memory 1050, a CXL storage 1052, a PCIe device 1054, and an accelerator (e.g., CXL device) 1056.

The first CPU 1010a, the second CPU 1010b, the GPU 1030, the NPU 1040, the CXL memory 1050, the CXL storage 1052, the PCle device 1054, and the accelerator 1056 may be commonly connected to the CXL switch 1015, and each may communicate with each other through the CXL switch (1015).

In some implementations, each of the first CPU 1010a, the second CPU 1010b, the GPU 1030, and the NPU 1040 may be the host device described with reference to FIG. 1 to FIG. 7, and they may be directly connected to individual memories 1020a, 1020b, 1020c, 1020d, and 1020e, respectively.

In some implementations, the CXL storage 1052 may be the storage device described with reference to FIG. 1 to FIG. 7,

By one or more of the first CPU 1010a, the second CPU 1010b, the GPU 1030, and the NPU 1040, at least some areas of the CXL memory 1050 and the memories 1060a and 1060b of the CXL storage 1052 may be allocated as a cache buffer of at least one of the first CPU 1010a, the second CPU 1010b, the GPU 1030, the NPU 1040, the CXL memory 1050, the CXL storage 1052, the PCIe device 1054, and the accelerator 1056.

CXL storage 1052 may generate a plurality of candidate voltages based on a power source voltage input from an external source. The CXL storage 1052 may generate analysis data including a plurality of state data indicating the state of the CXL storage 1052 by applying each of a plurality of candidate voltages to the CXL switch 1015, which transmits and receives a plurality of packets with the host. CXL storage 1052 may transmit analysis data to the host. CXL storage 1052 may drive CXL switch 1015 with driving voltage determined based on analysis data. Accordingly, the CXL storage 1052 may have the effect of maximizing electric power usage efficiency, reducing heat generation, and enabling dynamic voltage adjustment of the CXL switch 1015.

In some implementations, the CXL switch 1015 may be connected to the PCIe device 1054 or the accelerator 1056 configured to support various functions, and the PCle device 1054 or the accelerator 1056 may communicate with each of the first CPU 1010a, the second CPU 1010b, the GPU 1030, and the NPU 1040 through the CXL switch 1015, or may access the CXL memory 1050 and the CXL storage 1052.

In some implementations, the CXL switch 1015 may be connected to an external network 1060 or a fabric, and may be configured to communicate with an external server through the external network 1060 or the fabric.

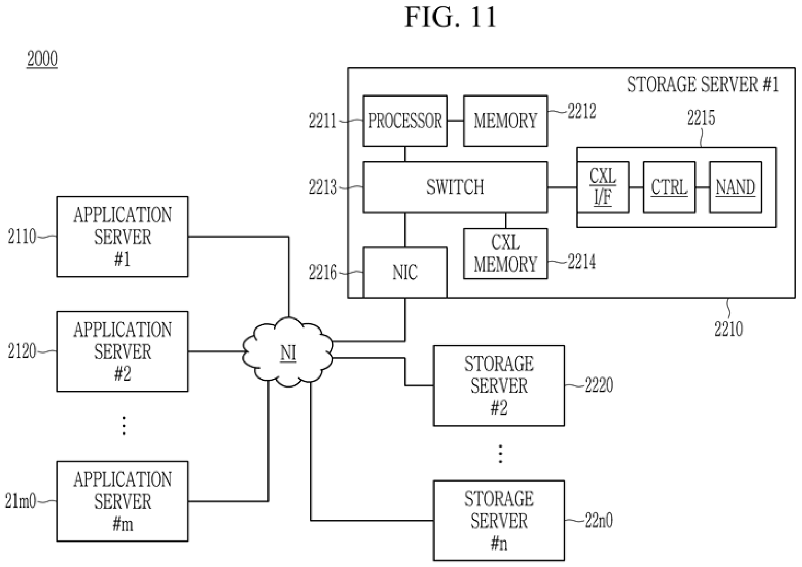

FIG. 11 illustrates a block diagram of a server system according to an implementation.

Referring to FIG. 11, a data center 1100 is a facility that collects various data and provides a service, and may be referred to as a data storage center. The data center 1100 may be a system for operating a search engine and database, and may be a computer system used in a business or government institution such as, but not limited to, a bank. The data center 1100 may include application servers (1110a, ..., 1110h) and storage servers (1120a, ..., 1120h). The number of the application servers and the number of the storage servers may be variously selected according to implementations, and the number of the application servers and the number of the storage servers may be different from each other.

Hereinafter, a configuration of a first storage server 1120a will be mainly described. Each of the application servers 1110a, ···, 1110h and each of the storage servers 1120a, ···, 1120h may have a structure similar to each other, and the application servers 1110a, ···, 1110h and the storage servers 1120a, ···, 1120h may communicate with each other through a network NT.

The first storage server 1120a may include a processor 1121, a memory 1122, a switch 1123, a storage 1125, a CXL memory 1124, and a NIC 1126. The processor 1121 may control overall operations of the first storage server 1120a, and may access the memory 1122 to execute an instruction loaded in the memory 1122 or process data. The processor 1121 and the memory 1122 may be directly connected, and the number of processor 1121 and the number of memory 1122 included in a storage server 1120 may be variously selected.

In some implementations, the processor 1121 and the memory 1122 may provide a processor-memory pair. In some implementations, the number of the processors 1121 and the number of the memories 1122 may be different. The processor 1121 may include a single-core processor and/or a multi-core processor. The above description of the storage server 1120 may be similarly applied to each of the application servers 1110a, ···, 1110h.

The switch 1123 may be configured to mediate or route communication between various constituent elements included in the first storage server 1120a. In some implementations, the switch 1123 may be a switch implemented based on the CXL protocol.

The CXL memory 1124 may be connected to the switch 1123.

The storage device 1125 may include a CXL interface circuit (CXL_IF), a controller (CTRL), and a NAND flash (NAND). The storage device 1125 may store data and/or output stored data according to a request of the processor 1121. In some implementations, the storage device 1125 may be a storage device described with reference to FIG. 1 to FIG. 7.

The storage device 1125 may generate a plurality of candidate voltages based on a power voltage input from an external source. The storage device (1125) may generate analysis data including a plurality of state data indicating the state of the storage device 1125 by applying each of a plurality of candidate voltages to a switch 1123 that transmits and receives a plurality of packets with the host. The storage device 1125 may transmit analysis data to the host. The storage device 1125 may drive the switch 1123 with a driving voltage determined based on the analysis data. Accordingly, the storage device 1125 may have the effect of maximizing power usage efficiency, reducing heat generation, and dynamically setting the voltage of the switch 1123.

In some implementations, the application servers 1110a, ···, 1110h may not include the storage 1125.

The NIC 1126 may be connected to the CXL switch 1123. The NIC 1126 may communicate with other storage servers 1120 or other application servers 1110 through the network NT.

In some implementations, the NIC 1126 may include a network interface card, a network adapter, and the like. The NIC 1126 may be connected to the network NT by a wired interface, a wireless interface, a Bluetooth interface, an optical interface, and the like. The NIC 1126 may include an internal memory, a digital signal processor (DSP), a host bus interface, and the like, and may be connected to the processor 1121 and/or the switch 1123 through the host bus interface. In some implementations, the NIC 1126 may be integrated with at least one of the processor 1121, the switch 1123, and the storage device 1125.

In some implementations, the network NT may be implemented by using a fiber channel (FC), Ethernet, or the like. In this case, the FC may refer to a medium used for relatively high-speed data transmission, and may use an optical switch that provides high performance/high availability. Depending on an access method of the network NT, the storage servers may be provided as a file storage, a block storage, or an object storage.

In some implementations, the network NT may be a storage-only network, such as, but not limited to, a storage area network (SAN). For example, the SAN may be an FC-SAN that uses an FC network and is implemented according to FC protocol (FCP). As another example, the SAN may be an IP-SAN that uses a TCP/IP network and is implemented according to an iSCSI (SCSI over TCP/IP or Internet SCSI) protocol. In some implementations, the network NT may be a general network such as, but not limited to, a TCP/IP network. For example, the network NT may be implemented according to a protocol such as, but not limited to, FC over Ethernet (FCoE), Network Attached Storage (NAS), and NVMe over Fabrics (NVMe-oF).

In some implementations, at least one of the application servers 1110a, ···, 1110h may store data requested to be stored by a user or a client in one of the storage servers 1120a, ···, 1120h through the network NT. At least one of the application servers 1110a, ···, 1110h may obtain data requested to be read by a user or a client from one of the storage servers 1120a, ···, 1120h through the network NT. For example, at least one of the application servers 1110a, ···, 1110h may be implemented as a web server or a database management system (DBMS).

In some implementations, at least one of the application servers 1110a, ···, 1110h may access a memory, a CXL memory, or a storage device included in another application server 1110a, ···, 1110h through the network NT, or may access memories, CXL memories, or storage devices included in the storage servers 1120a, ···, 1120h through the network NT. Accordingly, at least one of the application servers 1110a, ···, 1110h may perform various operations on data stored in other application servers and/or storage servers. For example, at least one of the application servers 1110a, ···, 1110h may execute an instruction to move or copy data between other application servers and/or storage servers. In this case, the data may be moved from the storage devices of the storage servers, through the memories or CXL memories of the storage servers, or directly to the memory or CXL memory of the application servers. Data moving through the network may be encrypted for security or privacy.

In some implementations, each constituent element or a combination of two or more constituent elements described with reference to FIG. 1 to FIG. 11 may be implemented as a digital circuit, a programmable or non-programmable logic device or array, an application specific integrated circuit (ASIC), or the like.

Embodiments are set out in the following Clauses:
Clause 1. A method of operating a storage system comprising:
   applying, by a host, a power voltage to a storage device;
   generating a plurality of candidate voltages based on the power voltage;
   generating analysis data including a plurality of state data, each of the plurality of state data indicating a respective state of the storage device that is based on a respective candidate voltage of the plurality of candidate voltages being applied to a host interface, the host interface being configured to transmit packets to and receive packets from the host;
   transmitting the analysis data to the host;
   generating, by the host, a selection signal that indicates one of the plurality of candidate voltages as a driving voltage; and
   driving, based on the selection signal, the host interface with the driving voltage.
Clause 2. A method of operating a storage system of Clause 1,
   wherein applying, by the host, the power voltage to the storage device comprising transmitting, from the host and to the storage device, a measurement start signal including data that indicates an execution time, and
   wherein generating the plurality of candidate voltages based on the power voltage comprising:
      determining, based on the measurement start signal, a total number of candidate voltages; and
      generating, based on a predetermined initial driving voltage that corresponds to the storage device, the plurality of candidate voltages, a number of the plurality of candidate voltages being equal to the determined total number of candidate voltages.
Clause 3. A method of operating a storage system of Clause 1 or Clause 2, wherein generating the plurality of candidate voltages based on the power voltage comprises:
   generating a plurality of quality data, each of the plurality of quality data indicating an attenuation degree of a respective signal that is transmitted to and received from the host interface, the respective signal being based on a respective candidate voltage of the plurality of candidate voltages being applied to the host interface.
Clause 4. A method of operating a storage system of Clause 3,
   wherein generating the analysis data comprising:
   generating first analysis data including first state data by applying a first candidate voltage of the plurality of candidate voltages to the host interface;
   determining that first quality data satisfies a predetermined quality criterion;
   generating, based on the first quality data satisfying the predetermined quality criterion, second analysis data including second state data by applying a second candidate voltage of the plurality of candidate voltages to the host interface; and
   generating the analysis data including the first analysis data and the second analysis data.
Clause 5. A method of operating a storage system of Clause 3,
   wherein generating the analysis data comprising:
   generating first analysis data including first state data by applying a first candidate voltage of the plurality of candidate voltages to the host interface;
   determining that first quality data fails to satisfy a predetermined quality criterion; and
   generating, based on the first quality data failing to satisfy the predetermined quality criterion, the analysis data including the first analysis data.
Clause 6. A method of operating a storage system of any of Clauses 1-5, wherein generating the selection signal comprises:
   determining a type of the storage device based on a connection location between the host and the storage device; and
   generating the selection signal based on the type of the storage device.
Clause 7. A storage device comprising:
   a host interface connected to a host, the host interface being configured to transmit and receive a plurality of packets;
   a voltage control module configured to
   generate a plurality of candidate voltages based on a power voltage that is input through a power port, and
   generate a power control signal based on a selection signal, the selection signal indicating one of the plurality of candidate voltages;
   an analysis module configured to generate a plurality of state data, each of the plurality of state data indicating a respective state of the storage device that corresponds to a respective candidate voltage of the plurality of candidate voltages; and
   a power management integrated circuit (PMIC) configured to generate, based on the power control signal, a driving voltage that drives the host interface.
Clause 8. A storage device of Clause 7, wherein:
   the host interface comprises a peripheral component interconnect express (PCIe) interface, and
   the plurality of state data include data on at least one selected from the group including speed, bandwidth, interface compatibility, reliability, and latency for signals that are transmitted to and received from the host interface.
Clause 9. A storage device of Clause 8, comprising:
   a quality monitoring module configured to generate a plurality of quality data, each of the plurality of quality data indicating a degree of attenuation of a respective signal transmitted to and received from the host interface, the respective signal being based on a respective candidate voltage of the plurality of candidate voltages being applied to the host interface,
   wherein each of the plurality of quality data is based on an eye open monitor (EOM) of the respective signal.
Clause 10. A storage device of Clause 9, wherein:
   the voltage control module is configured to
   determine that first quality data satisfies a predetermined quality criterion by applying a first candidate voltage of the plurality of candidate voltages to the host interface, and
   generate, based on the first quality data satisfying the predetermined quality criterion, analysis data including first state data that corresponds to the first candidate voltage.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A storage system comprising:
a host (100) configured to provide a power voltage, and
a storage device (200) configured to
generate (S103) a plurality of candidate voltages based on the power voltage,
generate (S105) analysis data including a plurality of state data, each of the plurality of state data indicating a respective state of the storage device (200) that is based on a respective candidate voltage of the plurality of candidate voltages being applied to a host interface (319), and
drive (S115) the host interface (319) with a driving voltage that is based on the analysis data, wherein the host interface (319) is configured to transmit packets to and receive packets from the host (100).

2. The storage system of claim 1, wherein:
the storage device (200) is configured to generate a plurality of quality data, each of the plurality of quality data indicating an attenuation degree of a signal transmitted from the host interface (319) and an attenuation degree of a signal received from the host interface (319), the respective signals being based on a respective candidate voltage of the plurality of candidate voltages being applied to the host interface (319).

3. The storage system of claim 2, wherein the storage device (200) is configured to:
generate (S1037) first analysis data including first state data by applying a first candidate voltage of the plurality of candidate voltages to the host interface (319);
determine (S1039) whether first quality data satisfies a predetermined quality criterion;
generate (S1037), based on the first quality data satisfying the predetermined quality criterion, second analysis data including second state data by applying a second candidate voltage of the plurality of candidate voltages to the host interface (319); and
transmit (S107), to the host (100), the analysis data including the first analysis data and the second analysis data.

4. The storage system of claim 2 or claim 3, wherein the storage device (200) is configured to:
generate (S1037) first analysis data including first state data by applying a first candidate voltage of the plurality of candidate voltages to the host interface (319),
determine (S1039) whether first quality data fails to satisfy a predetermined quality criterion, and
transmit (S107), based on the first quality data failing to satisfy the predetermined quality criterion, the analysis data including the first analysis data to the host (100).

5. The storage system of any of claims 2-4, wherein each of the plurality of quality data is based on an eye open monitor, EOM, of the respective signal.

6. The storage system of any preceding claim , wherein
the host (100) is configured to
generate (S109), based on the analysis data and a type of the storage device (200), a selection signal indicating one of the plurality of candidate voltages as the driving voltage; and
transmit (S111) the selection signal to the storage device (200),
wherein the type of the storage device (200) is based on a connection location between the host (100) and the storage device (200).

7. The storage system of any preceding claim, wherein the storage device (200) is configured to generate the plurality of candidate voltages based on a measurement start signal from the host (100), the measurement start signal including data that indicates an execution time, and
wherein a number of the plurality of candidate voltages is based on the execution time.

8. The storage system of claim 7, wherein
the measurement start signal is a vendor unique command signal.

9. The storage system of any preceding claim, wherein
the plurality of candidate voltages comprise a sequence of candidate voltages that have a constant voltage difference between adjacent candidate voltages, a maximum voltage of the sequence of candidate voltages being a predetermined initial setting voltage that corresponds to the storage device (200).

10. The storage system of any preceding claim, wherein
the host interface (319) comprises a peripheral component interconnect express interface,
the plurality of state data include data on at least one selected from the group including speed, bandwidth, interface compatibility, reliability, and latency for signals transmitted to and received from the host interface (319).

11. A method of operating a storage system comprising:
applying, by a host (100), a power voltage to a storage device (200);
generating (S103), by the storage device (200), a plurality of candidate voltages based on the power voltage;
generating (S105), by the storage device (200), analysis data including a plurality of state data, each of the plurality of state data indicating a respective state of the storage device (200) that is based on a respective candidate voltage of the plurality of candidate voltages being applied to a host interface (319) of the storage device (200), the host interface (319) being configured to transmit packets to and receive packets from the host (100);
transmitting (S107), by the storage device (200), the analysis data to the host (100);
generating (S109), by the host (100), a selection signal that indicates one of the plurality of candidate voltages as a driving voltage; and
driving (S115), by the host (100) and based on the selection signal, the host interface (319) with the driving voltage.

12. A method of operating a storage system of claim 11,
wherein applying, by the host (100), the power voltage to the storage device (200) comprises transmitting, from the host (100) and to the storage device (200), a measurement start signal including data that indicates an execution time, and
wherein generating (S103), by the storage device (200), the plurality of candidate voltages based on the power voltage comprises:
determining, based on the measurement start signal, a total number of candidate voltages; and
generating, based on a predetermined initial driving voltage that corresponds to the storage device (200), the plurality of candidate voltages, a number of the plurality of candidate voltages being equal to the determined total number of candidate voltages.

13. A method of operating a storage system of claim 11 or claim 12,
wherein generating (S103), by the storage device (200), the plurality of candidate voltages based on the power voltage comprises:
generating a plurality of quality data, each of the plurality of quality data indicating an attenuation degree of a respective signal that is transmitted to and received from the host interface (319), the respective signal being based on a respective candidate voltage of the plurality of candidate voltages being applied to the host interface (319).

14. A method of operating a storage system of claim 13,
wherein generating (S105), by the storage device (200), the analysis data comprises:
generating (S1037) first analysis data including first state data by applying a first candidate voltage of the plurality of candidate voltages to the host interface (319);
determining (S1039) whether first quality data satisfies a predetermined quality criterion;
generating (S1037), in response to the first quality data satisfying the predetermined quality criterion, second analysis data including second state data by applying a second candidate voltage of the plurality of candidate voltages to the host interface (319); and
generating the analysis data including the first analysis data and the second analysis data.

15. A storage device comprising:
a host interface (319) connected to a host (100), the host interface (319) being configured to transmit and receive a plurality of packets;
a voltage control module (3155) configured to
generate (S103) a plurality of candidate voltages based on a power voltage that is input through a power port (P23), and
generate a power control signal based on a selection signal, the selection signal indicating one of the plurality of candidate voltages;
an analysis module (3153) configured to generate a plurality of state data, each of the plurality of state data indicating a respective state of the storage device (200) that corresponds to a respective candidate voltage of the plurality of candidate voltages; and
a power management integrated circuit (210) configured to generate, based on the power control signal, a driving voltage that drives the host interface (319).
